# EUROPEAN PATENT SPECIFICATION

(11) **EP 2 156 445 B1**
(45) Date of publication and mention of the grant of the patent: **23.12.2015**
(21) Application number: 08761656.1
(22) Date of filing: 09.05.2008
(51) Int. Cl.: H01F 1/03, H01L 41/12

(54) **COMPOSITE MATERIAL BASED ON MSM EFFECT**
AUF MSM-EFFEKT BASIERENDER VERBUNDWERKSTOFF
MATÉRIAU COMPOSITE BASÉ SUR L'EFFET MSM

(30) Priority: 11.05.2007 FI 20075342
(43) Date of publication of application: 24.02.2010
(73) Proprietor: Aalto University Foundation, 00076 Aalto (FI)
(72) Inventor: HANNULA, Simo-Pekka, 00260 Helsinki (FI); HECZKO, Oleg, 00730 Helsinki (FI)
(74) Representative: LEITZINGER OY
(86) International application number: PCT/FI2008/050260
(87) International publication number: WO 2008/139034

(56) References cited:
- WO-A1-2004/078367
- US-A1- 2001 040 558
- US-B1- 6 515 382
- GANS ERIC ET AL: "Cyclic actuation of Ni-Mn-Ga composites" JOURNAL OF APPLIED PHYSICS, AMERICAN INSTITUTE OF PHYSICS. NEW YORK, US LNKD- DOI:10.1063/1.2190031, vol. 99, no. 8, 21 April 2006 (2006-04-21) , pages 84905-084905, XP012084210 ISSN: 0021-8979
- SÖDERBERG O, GE Y, SOZINOV A, HANNULA, LINDROOS VK: "Recent breakthrough development of the magnetic shape memory effect in Ni-Mn-Ga alloys" SMART MATERIALS AND STRUCTURE, vol. 14, 24 August 2005 (2005-08-24), pages S223-S235, XP002578084 DOI: 10.1088/0964-1726/14/5/009
- GANS E. ET AL.: 'Cyclic actuation of Ni-Mn-Ga composites' J. APPL. PHYS. vol. 99, no. 8, 2006, pages 084905-1 - 084905-4, XP012084210
- HINZ D. ET AL.: 'Polyester-bonded textured composites with single-chrystalline shape memory Ni-Mn-Ga particles' J. MAGN. MAGN. MATER. vol. 310, no. 2, 2007, pages 2785 - 2787, XP022023854
- HECZKO OLEG ET AL: "Magnetic shape memory effect in thin foils", APPLIED PHYSICS LETTERS, AMERICAN INSTITUTE OF PHYSICS, US, vol. 93, no. 2, 15 July 2008 (2008-07-15), pages 22503-22503, XP012112448, ISSN: 0003-6951, DOI: 10.1063/1.2957675

## Description

The application relates to the details of a micromechanical actuator or transducer using a magnetic shape memory material. The magnetic shape memory material, a so-called MSM material (another valid term is FSMA = Ferromagnetic Shape Memory Alloy), is a rather recent type of material, which undergoes double-boundary motion in response to a mechanical force or a magnetic field. The material only functions under the control of a magnetic field or is capable of establishing a magnetic field below a certain temperature. The abbreviation MSME refers to a magnetic shape memory effect. The transducer based on the MSM effect refers in this application to a transducer capable of converting a mechanical motion into a change of magnetic field or producing a mechanical motion originating from a change of magnetic field. The damper based on the MSM effect is a transducer discussed in this application, because the dampening properties are changed by means of a magnetic field.

MSM materials are capable of producing a motion considerably more extensive than those produced by magnetostrictive materials or piezoelectric materials. Accordingly, the MSM materials make a highly promising material for various actuators and especially for actuators in miniature size bracket. At present, the deformation attainable with certain Ni-Mn-Ga compositions, depending on a crystal structure, is typically within the range of 5-11% and more sizable deformations can be anticipated in the near future.

The MSM crystal can be cut for thin tabs or bars. These can be further used as dampers, sensors, and mechanical-motion producing actuators. The MSM element can be used for designing for example a micromechanical valve or pump, which is controlled by an external magnetic field. On the other hand, the element can be used as a sensor, the change of magnetic field being caused by a mechanical motion.

The MSM material must consist of correctly directed single crystal in order to achieve a maximum strain and efficiency. The deformation does not return by the deactivation of a magnetic field, but it takes an oppositely directed magnetic field or a mechanical counterforce to recover the original shape. This aspect causes trouble in many sensor and actuator applications. In micromechanical devices, the generation of a desired counterforce is often quite difficult. Springs, for example, are used in micromechanical devices for producing a counterforce. However, the inclusion of a separate spring in a micromechanical sensor is difficult or impossible, since a thin board, in particular, is likely to buckle and break as it is pre-loaded longitudinally.

It is an objective of the invention to enable the use of an MSM element in return-force demanding applications in a compact and simple manner. A particular objective is to design self-returning mechanisms of even smaller size than before. These objectives are achieved by a magnetically-mechanically active composite or sandwich material as defined in the independent claim 1.

The closest prior art is presented in Gans Eric et la: "cyclic actuator of Ni-Mn-Ga composites" Journal of Applied Physics, American Institute of Physics. New York, US LNKD-DOI:19.1063/1.2190031, vol 99, no. 8, 21 April 2006 (2006-04-21), PAGES 84905-084905, XP012084210 ISSN:0021-8979.

The publication presents a composite MSM actuator with polyurethane layer for generating return force. The MSM parts are cut with electric discharge. The MSM parts are described to be 1 mm thick. It doesn't present electropolishing.

The other related publication is: Söderberg O, Ge Y, Sozinov, A, Hannula, Lindroos VK: "present breakthrough development of magnetic shape memory effect in Ni-Mn-Ga alloys" Smart materials and structure, vol 14, 24 August 2005 (2005-08-24), pages S223-S235, DOI:10.1088/0964-1726/14/5/009

It presents way of minimizing surface stress by using electro polishing of the MSM test samples before microscopic and chemical analysis. The publication doesn't describe any benefits of very thin MSM parts in composite, and that the mobility of twin boundaries would not be sufficient for thin MSM-parts to work properly in composite.

The invention is based on a combination of a thin or narrow MSM material and polymer or elastomer. The MSM material can be conveniently manufactured in the thickness of 70 or just 50 micrometers or even thinner by using a combination of mechanical and electropolishing. A thickness-reducing electropolishing can be performed with an HNO₃ ethanol solution of at least 25% at room temperature or cooler than that. These thin tabs or bar-shaped pieces can be used for constructing actuators. According to the invention, a tab of MSM material is in an appropriate manner adjoined with an elastic material. The elastic material can be a one-sided coating or in some cases it can be applied on both sides, or the elastic material can be used for bonding several MSM tabs or bars to each other for a larger single element.

Regarding its elastic modulus and thickness, the elastic material is selected in view of providing the MSM element with an appropriate return force or pre-load. In a typical application, the elastic coating has its stiffness or load in the order of 20 MPa, which is attainable for example with synthetic rubber. Other suitable materials include several polymers, polyurethane, epoxy, silicone plastics. In certain conditions, a super-elastic shape memory material may also be useful, although electrical conductivity is generally not a desired property. This results in a small-size element, which does not need an external mechanical pre-load or bias force in order to recover a desired dimension after the deactivation of a magnetic field. The pre-load or return force generated by an elastic material enables in both sensor and actuator applications a recovering action without a separate spring element or the reversal of a magnetic field.

According to the invention, the elastic material has been bonded to the surface of an MSM element itself. It can be for example a coating, a pasted or vulcanized film. The film can also be pre-loaded prior to bonding, or the coating or the film can be made of a post-bonding shrinkable material, for example heat-shrinkable polymer or a material chemically shrinkable upon setting or a glutinous or varnish type material based on the evaporation of a solvent. Prior known are pre-loading or return springs associated with MSM or magnetostrictive structures. These are nevertheless separate structural members, such as an elastic element 12 shown in the abstract figure of US5184037. The solution according to the invention is a remarkably compact, integrated composite structure. It should be noted that the properties of a magnetostrictive material differ considerably from those of an MSM material, the cited publication not being directly related to the technology of this application.

Exemplary embodiments of the invention shall now be described with reference to the accompanying drawings.
- Fig. 1: shows a composite element of the invention in cross-section;
- Fig. 2: shows a second composite element of the invention in cross-section;
- Fig. 3: shows a wave-motion generating structure in cross-section;
- Fig. 4: shows a composite structure in a schematic example.

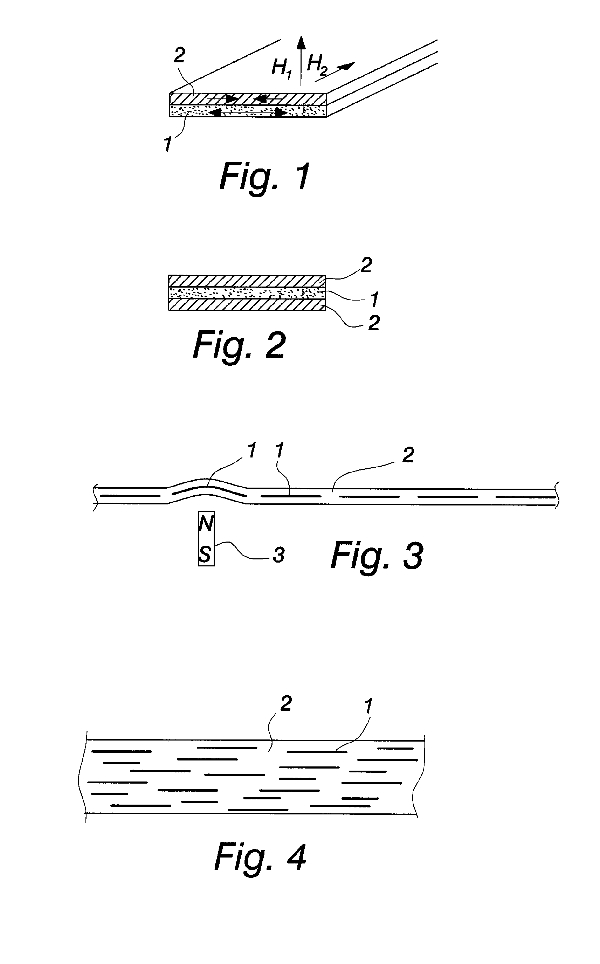

Fig. 1 illustrates a board-like structure of the prior art, wherein the surface of an MSM material in an element 1 is provided with a return-force generating element 2 of an elastic material. The magnetic field can be co-directional with an arrow H1 or optionally with H2. The return-force generating element can be a coating, a pasted or vulcanized film or may also consist for example of coating stripes or surface-bonded yarns or fibers, which are oriented to be substantially co-directional with a desired returning force.

Fig. 2 illustrates a board-like MSM element 1 coated or covered on both sides with an elastic material 2.

According to fig. 3, inside the elastic material 2 can be integrated MSM boards 1 capable of shape-shifting in such a way that the elastic material develops a wave motion in its surface as a result of moving a magnetic field along the surface. A mobile magnetic field can be generated by moving a magnet 3 or by using a sequential row of electromagnets. The elastic material 3 can have bonded its surface, for example by pasting or vulcanizing, a number of MSM elements which can be further coated with an elastic material for protecting the MSM elements thereby. This results in a pliable board capable of bending locally in response to a magnetic field. In this example, the MSM elements 1 are subjected to a shape-shifting process which involves bending as opposed to a change of length described above. The solution can be used for example for manufacturing a small-size conveyor, or also in user interface solutions which enable generating a tactile signal. Feasible applications include for example vibratory telephone alarm, retexturing or vibrating the top surfaces of keys. The element of fig. 3 may also function as a sensor.

Fig. 4 illustrates a sandwich or composite structure according to the invention. Several MSM elements 1 and elastic layers 2 can be laid on top of each other for making a composite sandwich material, which can be used for constructing a larger actuator. It should be noted that, since the exciter is constituted by a magnetic field, there is no need for conductor layers between the laminations, which would be needed in connection with piezoelectric sandwich structures. That is, the sandwich material works by itself in the same intended application as a single-crystal MSM element.

However, by virtue of an internal pre-load, the difference is a self-returning ability. This may enable a simple structure to provide a plurality of useful applications, the satisfactory implementation of which is currently impossible with an MSM element. The composite material can have the size or properties of its elements and the thickness of its elastic material varying in a controlled fashion, for example in line with a certain statistical distribution. This enables working on the properties of a sandwich material according to the invention for a desired application. The material can be a composite consisting of pieces of an MSM material in various sizes, wherein the elastic material functions as a bonding agent and a return-force generating element. The pieces of an MSM material may also come in random sizes and shapes as long as the crystals are unidirectional. Another advantage of the sandwich structure is that it does not require a large single crystal but, instead, it enables combining crystals of several production batches for a composite material more consistent in quality. In this application as well, the crystals are preferably electropolished for reducing surface defects.

The procedure of directing the crystals can be carried out in such a way that the composite material, which contains crystals and is in a viscous, still unset state, can be subjected to an alternating magnetic field and to a shape change in phase by an external force. The forced shape change can be slightly in excess of a change of length in the magnetic material, whereby the MSM pieces with an absolutely correct orientation are also subjected to a minor force generated by the viscous material. As a result of this, the pieces of MSM material reorientate themselves within the viscous material so as to generate a motion parallel to and in phase with the external forced motion. Once the pieces of MSM material have been properly oriented, the viscous material can be set by a heat treatment or the bonding material used in the composite can be selected to be a sufficiently slow-setting substance, such that the orientation can be performed before the composite has set.

Prior to the setting of a bonding agent, the magnetic field and the piece of a composite material in terms of its shape are worked out in such a way that, after the setting process, the pieces of MSM material retain a returning pre-load. The pieces of MSM material can be brought to their contracted form by means of the magnetic field and at the same a pre-load can be slowly generated in the bonding agent in the early stages of setting. The selected bonding agent can also be a polymer, which shrinks or reshapes itself for example in response to a heat treatment or a chemical reaction after the setting so as to generate a returning pre-load.

An elastic flexible element according to the invention, for example a polymer, super-elastic shape memory metal or elastomer coating, improves also the durability and handling of micromechanical components. The MSM actuator does not require any electrode in its surface and, hence, the polymer coating does not interfere with the progress of an exciting magnet or a magnetic signal, even at relatively high signal frequencies. The absence of an electrode is an advantage for example in the process of constructing a pump or a valve as the actuator can be totally embedded within an inert material and control of the MSM actuator does not require any vias for an electrode. The solution according to the invention enables the fabrication of a smaller-than-before actuator and at the same the layer 2 of a pliable material may function as a chemical protection for the MSM material. Furthermore, the use of a dielectric pliable substance in the composite material results in reduced eddy-current losses as the crystals within the composite material are enveloped by a dielectric substance and the conducting MSM elements are small in size. This is another fact that reduces high-frequency losses. Electropolished crystals or boards lend themselves more easily than large pieces to flawless fabrication and, thus, the composite material can be of high quality in terms of its properties and, in addition, at high frequencies the eddy-current losses are decidedly lesser than those occurring in a single-crystal material. The electropolishing improves the functionality of MSM pieces present in a composite material or composite elements, because the crystal structure has a surface which is closer to perfect.

At the same time, the elastic material may function as a joining element for the rest of a micromechanical structure. An example of this is the above-mentioned wave-motion generating board and the sandwich structure consisting of several MSM boards and an elastic material. Depending on a direction of movement, the elastic material itself may also function as a fastening element. Moreover, the composite element can be mechanically flexible in one direction, yet able to generate even major forces in the other direction. For example, a board-like material can be quite pliable in the process of bending, but may still expand in one direction with a major force. The composite element or an element of the invention manufactured in a composite material can be shaped for many applications. In addition, the traveling path established thereby can be selected by varying the crystal orientation. Furthermore, the damper elements can be conveniently constructed as a combination of a spring made in an elastic material and an adjustable damper.

## Claims

1. A magnetically-mechanically active composite or sandwich material that contains several small elements (1) having a smallest dimension less than 1 millimeter and consisting of a magnetic shape memory material and bonded to each other with an elastic bonding agent (2), which is adapted to generate a returning force for the magnetic shape memory material elements, **characterized in that** the magnetic shape memory material elements (1) are electropolished before the composite material is prepared.

2. A magnetically-mechanically active composite material as set forth in claim 1, **characterized in that** the bonding agent (2) is selected from a group consisting of: a polymer, a heat-shrinkable polymer, an elastomer, a silicone plastic, rubber, a synthetic rubber or a super-elastic alloy.

3. An active composite material as set forth in claim 1 or 2, wherein the pre-load of a bonding agent, which generates a returning force, is provided by setting the bonding agent while the magnetic shape memory material elements are in a returned state, or by selecting a bonding agent which generates, after the curing or setting, a pre-loading force by shrinking.

4. A composite material as set forth in any of the preceding claims, **characterized in that** the magnetic shape memory material elements (1) have a smallest dimension which is less than 0.1 millimeter.

5. A method for the preparation of an active composite or sandwich material, **characterized in that** the electropolished active magnetic shape memory material elements (1) of the composite material are oriented during manufacturing of the composite material while the bonding agent (2) of the composite is still in a viscous or uncured state by subjecting the composite material simultaneously to a reversible magnetic field and to an in-phase varying mechanical deformation, so that the pieces of magnetic shape memory material re-orientate themselves within the viscous material so as to generate motion parallel to and in phase with the external forced motion, and after the re-orientation the bonding agent (2) is set into a state that the bonding agent is adapted to generate return force for the magnetic shape elements (1) in the composite material.

6. The use of a material as set forth in any of the preceding claims 1 - 4 in conveyors for generating a wave motion by means of a mobile magnetic field.

7. The use of a material as set forth in any of the preceding claims 1 - 4 in a user interface operating by means of tactile sensation.

8. The use of a material as set forth in any of the preceding claims 1 - 4 as a transducer element, a sensor, a damper or an actuator.

9. The use of material as set forth in claim 6 - 8, **characterized in that** a composite or sandwich material according to any of claims 1 - 4 is used for working out a flat element, which is adapted to bend in response to a magnetic field or to generate, during the process of bending, a magnetic field, and the element comprises, within its active region, substantially at least one layer of magnetic shape memory material elements.

## Patentansprüche

1. Magnetisch-mechanisch aktiver Verbundwerkstoff oder geschichtetes Material, das mehrere kleine Elemente (1) enthält, die eine kleinste Dimension kleiner als 1 Millimeter aufweisen und aus einem magnetischen Formgedächtnismaterial bestehen und mit einem elastischen Bindemittel (2) miteinander verbunden sind, das dafür ausgelegt ist, um eine Rückstellkraft für die Elemente des magnetischen Formgedächtnismaterials zu erzeugen, **dadurch gekennzeichnet, dass** die Elemente (1) des magnetischen Formgedächtnismaterials elektrolytisch poliert werden, bevor der Verbundwerkstoff hergestellt ist.

2. Magnetisch-mechanisch aktiver Verbundwerkstoff nach Anspruch 1, **dadurch gekennzeichnet, dass** das Bindemittel (2) ausgewählt ist aus einer Gruppe, die aus dem Folgenden besteht: aus einem Polymer, einem wärmeschrumpfenden Polymer, einem Elastomer, einem Silikonkunststoff, Kautschuk, einem synthetischen Kautschuk oder aus einer superelastischen Legierung.

3. Aktiver Verbundwerkstoff nach Anspruch 1 oder 2, wobei die Vorspannkraft eines Bindemittels, das eine Rückstellkraft erzeugt, bereitgestellt wird, indem das Bindemittel festgesetzt wird, während die Elemente des magnetischen Formgedächtnismaterials in einem zurückgezogenen Zustand sind, oder indem ein Bindemittel ausgewählt wird, das nach dem Härten oder Festsetzen durch Schrumpfen eine Vorspannkraft erzeugt.

4. Verbundwerkstoff nach einem der vorhergehenden Ansprüche, **dadurch gekennzeichnet, dass** die Elemente (1) des magnetischen Formgedächtnismaterials eine kleinste Dimension aufweisen, die kleiner als 0,1 Millimeter ist.

5. Verfahren zur Herstellung eines aktiven Verbundwerkstoffs oder eines geschichteten Materials, **dadurch gekennzeichnet, dass** die elektrolytisch polierten, aktiven Elemente (1) des magnetischen Formgedächtnismaterials des Verbundwerkstoffs während der Herstellung des Verbundwerkstoffs orientiert werden, während das Bindemittel (2) des Verbundwerkstoffs noch in einem viskosen oder ungehärteten Zustand ist, indem der Verbundwerkstoff gleichzeitig einem reversiblen magnetischen Feld und einer in Phase variierenden mechanischen Verformung unterworfen werden, so dass die Stücke von dem magnetischen Formgedächtnismaterial sich selbst innerhalb des viskosen Materials erneut orientieren, um eine Bewegung parallel zu und in Phase mit der äußeren erzwungenen Bewegung zu erzeugen, und dass nach der erneuten Orientierung das Bindemittel (2) in einen Zustand derart gesetzt wird, dass das Bindemittel dafür ausgelegt ist, eine Rückstellkraft für die magnetischen Formelemente (1) in dem Verbundwerkstoff zu erzeugen.

6. Verwendung eines Materials nach einem der vorhergehenden Ansprüche 1 bis 4 in Beförderungsmitteln, um eine Wellenbewegung mittels eines mobilen magnetischen Feldes zu erzeugen.

7. Verwendung eines Materials nach einem der vorhergehenden Ansprüche 1 bis 4 in einer Anwenderschnittstelle, die mittels taktiler Sinnesempfindungen betrieben wird.

8. Verwendung eines Materials nach einem der vorhergehenden Ansprüche 1 bis 4 als ein Messwertaufnehmerelement, einen Sensor, ein Dämpfungselement oder als eine Betätigungsvorrichtung.

9. Verwendung eines Materials nach Anspruch 6 bis 8, **dadurch gekennzeichnet, dass** ein Verbundwerkstoff oder geschichtetes Material nach einem der Ansprüche 1 bis 4 für die Ausarbeitung eines flachen Elements verwendet wird, das dafür ausgelegt ist, um sich als Reaktion auf ein magnetisches Feld zu biegen oder um während des Prozesses des Biegens ein magnetisches Feld zu erzeugen, und wobei das Element innerhalb seines aktiven Bereichs mindestens eine Schicht von Elementen des magnetischen Formgedächtnismaterials umfasst.

## Revendications

1. Matériau composite ou sandwich magnétiquement-mécaniquement actif qui contient de nombreux petits éléments (1) ayant une plus petite dimension inférieure à 1 millimètre et comprenant un matériau à mémoire de forme magnétique et liés l'un a l'autre à l'aide d'un agent de liaison élastique (2), qui est adapté de façon à générer une force de retour pour les éléments du matériau à mémoire de forme magnétique, **caractérisé en ce que** les éléments du matériau à mémoire de forme magnétique (1) sont électropolis avant que le matériau composite ne soit préparé.

2. Matériau composite magnétiquement-mécaniquement actif selon la revendication 1, **caractérisé en ce que** l'agent de liaison (2) est choisi parmi un groupe constitué d'un polymère, d'un polymère rétrécissable à la chaleur, d'un élastomère, d'un plastique en silicium, de caoutchouc, d'un caoutchouc synthétique ou d'un alliage super élastique.

3. Matériau composite actif selon la revendication 1 ou la revendication 2, dans lequel la pré-charge d'un agent de liaison, qui génère une force de retour, est fournie en plaçant l'agent de liaison pendant que les éléments du matériau à mémoire de forme magnétique sont dans un état de retour, ou en sélectionnant un agent de liaison qui génère, après le durcissement ou le placement, une force de pré-charge par rétrécissement.

4. Matériau composite selon l'une quelconque des revendications précédentes, **caractérisé en ce que** les éléments du matériau à mémoire de forme magnétique (1) ont une plus petite dimension qui est inférieure à 0.1 millimètre.

5. Procédé de préparation d'un matériau composite ou sandwich actif, **caractérisé en ce que** les éléments du matériau à mémoire de forme magnétique actifs électropolis (1) du matériau composite sont orientés pendant la fabrication du matériau composite pendant que l'agent de liaison (2) du composite est encore dans un état visqueux ou non durci en soumettant simultanément le matériau composite à un champ magnétique réversible et à une déformation mécanique variant selon la phase, de sorte que les pièces du matériau à mémoire de forme magnétique se réorientent d'elles-mêmes au sein du matériau visqueux de façon à générer un mouvement parallèle à la phase et en phase avec le mouvement forcé externe, et après la réorientation l'agent de liaison (2) est placé dans un état dont l'agent de liaison est adapté pour générer la force de retour pour les éléments de forme magnétique (1) dans le matériau composite.

6. Utilisation d'un matériau selon l'une quelconque des revendications précédentes 1 à 4 dans des convoyeurs pour la génération d'un mouvement ondulatoire par le biais d'un champ magnétique mobile.

7. Utilisation d'un matériau selon l'une quelconque des revendications précédentes 1 à 4 dans une interface d'utilisateur fonctionnant par le biais d'une sensation tactile.

8. Utilisation d'un matériau selon l'une quelconque des revendications précédentes 1 à 4 en tant qu'un élément de transduction, un capteur, un clapet ou un actionneur.

9. Utilisation d'un matériau selon les revendications 6 à 8, **caractérisé en ce qu'**un matériau composite ou sandwich selon l'une quelconque des revendications 1 à 4 est utilisé pour élaborer un élément plat, qui est adapté pour se plier en réponse à un champ magnétique ou pour générer, pendant le processus de pliage, un champ magnétique, et l'élément comprend, au sein de sa région active, essentiellement au moins une couche d'éléments de matériaux à mémoire de forme magnétique.
